# EUROPEAN PATENT APPLICATION

(11) **EP 1 494 515 A2**
(43) Date of publication of application: **05.01.2005**
(21) Application number: 04012911.6
(22) Date of filing: 01.06.2004
(51) Int. Cl.: H05K 3/34

(54) **Electronic component mounting method, substrate manufacturing apparatus, and circuit board**

(30) Priority: 02.07.2003 JP 2003190339
(71) Applicant: Kabushiki Kaisha Toshiba, Tokyo 105-8001 (JP)
(72) Inventor: Happoya, Akihiko, Toshiba Corporation, Minato-ku Tokyo 105-8001 (JP)
(74) Representative: Henkel, Feiler & Hänzel

(57) **Abstract**

An electronic component mounting method of mounting an electronic component provided with a lead wire (60) on a printed wiring board (10), comprises printing a cream solder (50) on a through hole (20) to which the lead wire (61) of the electronic component provided with the lead wire (60) inserted, inserting the electronic component provided with the lead wire (60) into the through hole (20) on which the cream solder (50) has been printed, and soldering the lead wire (61) of the electronic component provided with the lead wire (60) inserted into the through hole (20) onto the through hole (20).

## Description

The present invention relates to an electronic component mounting method in which a through hole is used and in which an electronic component provided with a lead wire is a mounting target, a substrate manufacturing apparatus, and a circuit board.

Various improvements and enhancements have been intended constantly in consideration of cost performance in each working process in a multilayered printed wiring board (see Jpn. Pat. Appln. KOKAI Publication No. 7-273453, for example).

In a process in which a lead wire of an electronic component provided with the lead wire is inserted into a through hole to solder the component onto a printed wiring board, solder is not raised to an upper part of a through hole (is not sufficiently filled) in some case.

When the printed wiring board is formed in a product while keeping this soldered/mounted state, the product is remarkably vulnerable to vibration, external stress and the like. Especially in electronic apparatuses such as a personal computer, various connector components to which an external stress is added need to be mounted as electronic components provided with the lead wires on a circuit board. When soldered portions of component mounted portions are cracked, needless to say, troubles are caused in an operation and a function of the electronic apparatus on which, for example, a printing unit is mounted, and many problems are caused in various aspects such as durability and reliability.

A phenomenon in which the solder does not rise as described above tends to be frequently seen, especially when solder wettability in the through hole drops by the surface mounting of two front and back surfaces, when a board thickness of the printed wiring board is large, or when a solder material is specified. When the surface mounting is performed twice on the front and back surfaces, a surface treatment is degraded, and solder wettability in the through hole drops. Therefore, even when the electronic component provided with the lead wire is inserted into the through hole and soldered after the surface mounting, the solder does not rise to the upper part of the through hole. As compared with a tin-lead based eutectic solder which has heretofore been general, a tin-silver-copper based lead-free solder tends not to rise. It is to be noted that the use of the tin-lead based eutectic solder is severely restricted in an environmental aspect, and therefore use of the lead-free solder in which lead in the solder used in the soldering is eliminated has been promoted. Therefore, even when the lead wire of the electronic component provided with the lead wire is inserted into the through hole of the printed wiring board, and soldered with the lead-free solder, the solder needs to be sufficiently raised to the upper part of the through hole.

As described above, there has not heretofore been any effective means for removing a disadvantage that the solder is not raised to the upper part of the through hole (not sufficiently filled), when the lead wire of the electronic component provided with the lead wire is inserted in the through hole, and soldered.

An electronic component mounting method of mounting an electronic component provided with a lead wire on a printed wiring board, according to a first aspect of the present invention is characterized by comprising: printing a cream solder on a through hole to which the lead wire of the electronic component provided with the lead wire is inserted; inserting the electronic component provided with the lead wire into the through hole on which the cream solder has been printed; and soldering the lead wire of the electronic component provided with the lead wire inserted into the through hole onto the through hole.

A substrate manufacturing apparatus in which an electronic component provided with a lead wire is mounted on a printed wiring board to manufacture a circuit board, according to a second aspect of the present invention is characterized by comprising: solder printing means for printing a cream solder onto a through hole of the printed wiring board, into which the lead wire of the electronic component provided with the lead wire is to be inserted; lead insertion means for inserting the electronic component provided with the lead wire into the through hole of the printed wiring board, onto which the cream solder has been printed; and soldering means for soldering the lead wire of the electronic component provided with the lead wire inserted in the through hole onto the through hole.

A circuit board according to a third aspect of the present invention is characterized by comprising: a through hole into which a lead wire of an electronic component provided with the lead wire coated beforehand with a cream solder is inserted from a surface coated with the cream solder and onto which the lead wire is soldered to mount the electronic component.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a diagram showing a soldering mounting process of an electronic component provided with a lead wire in a first embodiment of the present invention;
FIG. 2 is a diagram showing the soldering mounting process of the electronic component provided with the lead wire in a second embodiment of the present invention;
FIGS. 3A to 3K are diagrams showing the soldering mounting process of the electronic component provided with the lead wire in a third embodiment of the present invention;
FIGS. 4A to 4I are diagrams showing the soldering mounting process of the electronic component provided with the lead wire in a fourth embodiment of the present invention;
FIGS. 5A to 5J are diagrams showing the soldering mounting process of the electronic component provided with the lead wire in a fifth embodiment of the present invention;
FIG. 6 is a diagram showing a solder rising state of a through hole, when the present invention is applied; and
FIG. 7 is a diagram showing a defect of a solder rising in the through hole in contrast to FIG. 6.

Embodiments of the present invention will be described hereinafter with reference to the drawings.

First, a first embodiment of the present invention will be described.

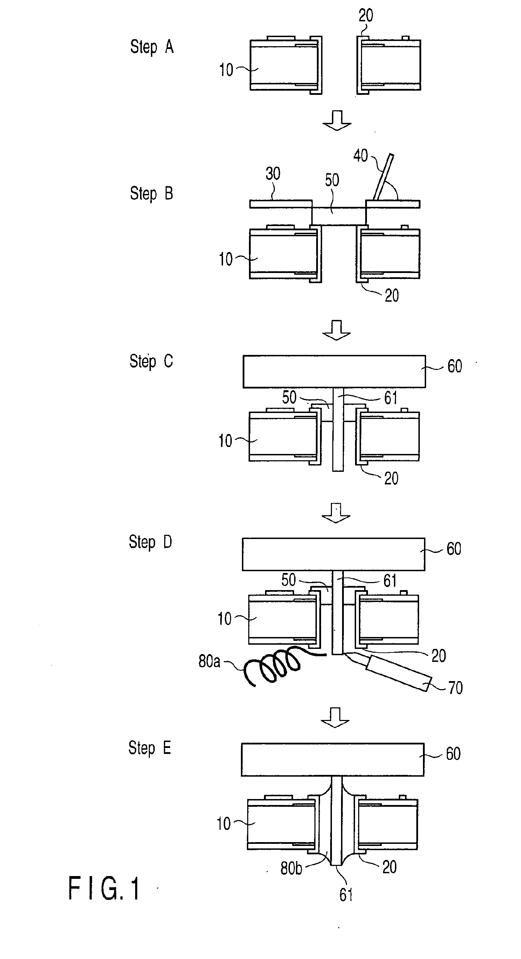

FIG. 1 is a diagram showing a soldering mounting process of an electronic component provided with a lead wire in a first embodiment of the present invention. In each embodiment, constituting elements are shown in cross sections.

In steps (steps A to E) shown in FIG. 1, a printed wiring board 10 is a mounting target of an electronic component provided with a lead wire 60. A through hole 20 is disposed in a component mounting portion provided with the lead wire on the printed wiring board 10, and a lead wire 61 of the electronic component provided with the lead wire 60 is inserted into the through hole 20, and subsequently the lead wire 61 is soldered.

A metal mask 30 has a mask pattern for printing a cream solder 50 so as to close a land of the through hole 20 into which the lead wire 61 of the electronic component provided with the lead wire 60 disposed in a lead component mounting portion of the printed wiring board 10 is inserted. A squeeze 40 prints the cream solder 50 in the lead component mounting portion of the printed wiring board 10 using the metal mask 30. The cream solder 50 is printed on a land portion of the through hole 20 disposed in the lead component mounting portion on the printed wiring board 10 using the metal mask 30 and squeeze 40.

The electronic component provided with the lead wire 60 is an electronic component which is a mounting target onto the printed wiring board 10, and comprises lead wires such as connectors and plugs to which an external stress is applied when formed into products. The lead wire 61 is disposed on the electronic component provided with the lead wire 60, and here only one lead is shown.

When the lead wire 61 of the electronic component provided with the lead wire 60 is inserted into the through hole 20, and soldered, and when the solder does not sufficiently rise by a soldering iron 70, the solder is corrected using a thread solder 80a. A solder 80b is charged in the through hole 20.

A lead soldering process of the electronic component provided with the lead wire 60 according to the first embodiment of the present invention will be described in order of steps with reference to FIG. 1.

A plurality of through holes 20 are disposed in the soldering process shown in FIG. 1, but a through hole is shown and described for the sake of convenience of description.

In step A, the printed wiring board 10 which is the mounting target of the electronic component provided with the lead wire 60 is projected as a component mounted printed wiring board into a mounting line of a soldering component.

In step B, the cream solder 50 is printed on the through hole 20 disposed in the lead component mounting portion of the printed wiring board 10 using the metal mask 30 and squeeze 40 so as to close the land of the through hole 20 from a wiring board upper surface.

In step C, the lead wire 61 of the electronic component provided with the lead wire 60 is inserted into the through hole 20 on which the cream solder 50 has been printed on the lead component mounting portion of the printed wiring board 10 on which the cream solder 50 has been printed.

In step D, the lead wire 61 inserted in the through hole 20 is soldered from the undersurface of the through hole 20 using the soldering iron 70 and thread solder 80a. Accordingly, the thread solder 80a is molten, and the molten solder is charged upwards from the undersurface of the through hole 20. Furthermore, in this case, the cream solder 50 printed on the upper surface of the through hole 20 undergoes heat of the soldering iron 70 and is molten, and the molten solder is charged downwards from the upper surface of the through hole 20.

Step E is a check step of soldering mounting, the solder 80b is uniformly charged in the through hole 20 by the soldering from the undersurface of the through hole 20 in the step D, and the lead soldering in the through hole 20 is performed in such a manner that the solder satisfactorily rises, that is, the solder is sufficiently charged.

Next, a second embodiment of the present invention will be described.

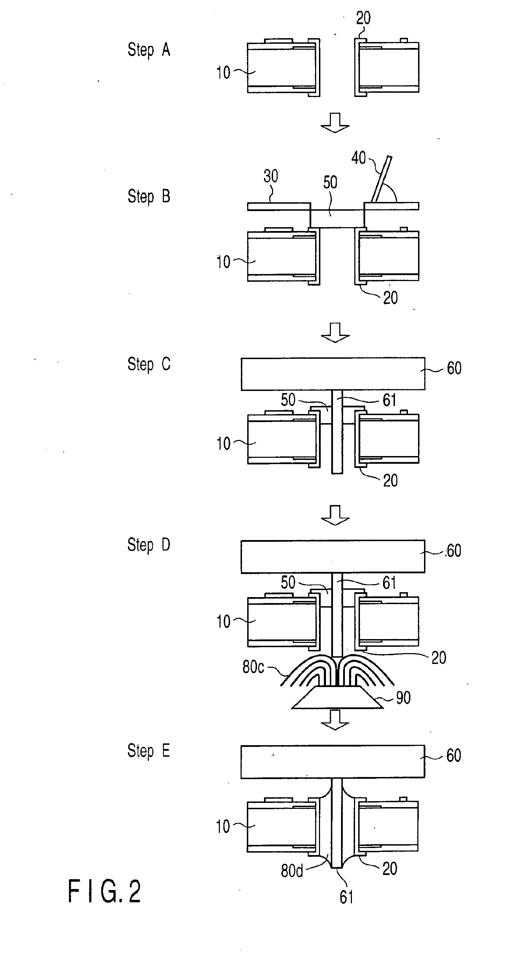

FIG. 2 is a diagram showing the soldering mounting process of the electronic component provided with the lead wire in a second embodiment of the present invention. In FIG. 2, the same components as those of FIG. 1 are denoted with the same reference numerals, and detailed description is omitted.

A solder jet portion 90 of a flow device (hereinafter referred to simply as the "flow device") spouts a solder 80c.

In the second embodiment shown in FIG. 2, the steps A to C are similar to those of the first embodiment.

In step D, the lead wire 61 inserted in the through hole 20 is soldered from the undersurface of the through hole 20 by the solder 80c spouted from the flow device 90. Accordingly, the jet solder 80c of the flow device 90 is charged upwards from the undersurface of the through hole 20. Further in this case, in the same manner as in the first embodiment, the cream solder 50 printed on the upper surface of the through hole 20 undergoes a jet solder heat of the flow device 90, and is molten, and the molten solder is charged downwards from the upper surface of the through hole 20.

Step E is a step of checking the soldering mounting, and here the lead soldering in the through hole 20 is performed by the soldering of the flow device 90 from the undersurface of the through hole 20 in the step D in such a manner that the solder satisfactorily rises, that is, the solder is sufficiently charged.

Next, a third embodiment of the present invention will be described.

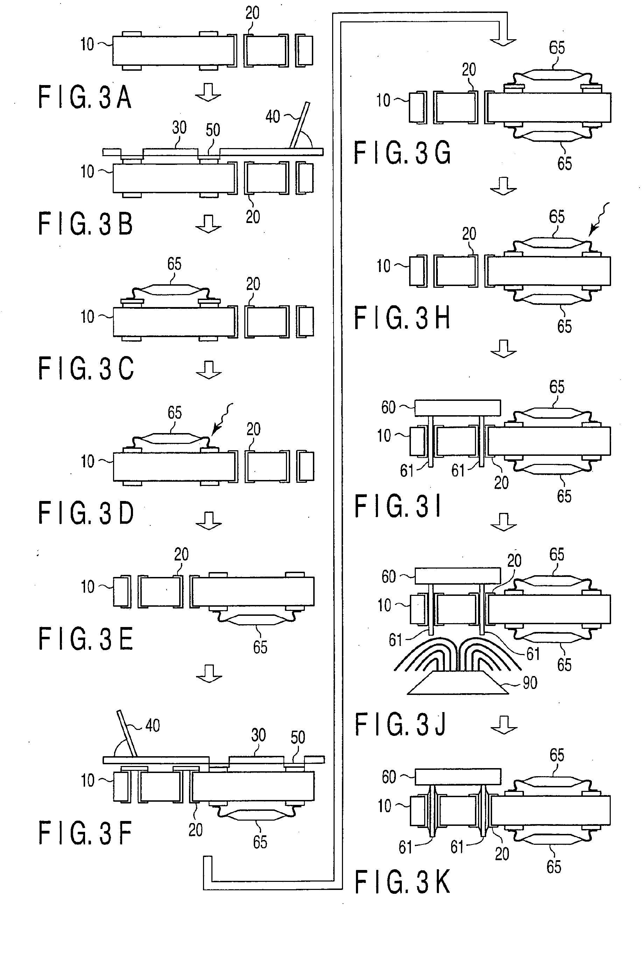

A soldering mounting process of the electronic component provided with the lead wire in the third embodiment of the present invention is shown in FIGS. 3A to 3K.

In the third embodiment, the flow device 90 of the step D shown in FIG. 2 is disposed in a reflow zone of a surface mounting component, and the lead wire 61 disposed in the electronic component provided with the lead wire 60 is securely molten and soldered/bonded by the cream solder 50 using the heat in the reflow zone. In other words, in the third embodiment, while keeping a remaining heat state of the printed wiring board 10 heated in the reflow zone, the component lead wire 61 is soldered by the flow device 90 in the step D shown in FIG. 2. Accordingly, a soldering time of the component lead wire 61 by the flow device 90 is shortened, and the melting and solder bonding by the cream solder 50 are further secured.

In a first reflow process shown in FIGS. 3A to 3D, a surface mounting component 65 is mounted and soldered on one surface (e.g., front surface) of the printed wiring board 10. Subsequently, in a second reflow process shown in FIGS. 3E to 3H, the surface mounting component 65 is mounted on the other surface (e.g., the back surface) of the printed wiring board 10. Subsequently, in a flow process shown in FIGS. 3I to 3K, the electronic component provided with the lead wire 60 is mounted, for example, on the front surface of the printed wiring board 10, and soldered by the jet solder of the flow device 90 from the back surface.

In the first reflow process shown in FIGS. 3A to 3D, in a step shown in FIG. 3A, the printed wiring board 10 is projected as a component mounted printed wiring board into a reflow line. In a step shown in FIG. 3B, the cream solder 50 is printed (coated), for example, on the surface mounting portion of the front surface of the printed wiring board 10 projected in the reflow line using the squeeze 40, the metal mask 30 and the like. In a step shown in FIG. 3C, the surface mounting component 65 is mounted on the surface mounting portion on which the cream solder has been printed. In a step shown in FIG. 3D, the surface mounting component 65 mounted on the surface mounting portion is soldered by a reflow device. Since the surface mounting component 65 is soldered by melting the solder 50 in the process shown in FIG. 3D, the solder 50 after melting is not shown in FIG. 3D. This omission of showing the molten solder is similar to the following figures.

Subsequently, in the second reflow process shown in FIGS. 3E to 3H, in a step shown in FIG. 3E, the surface-treated printed wiring board 10 is reversed. In a step shown in FIG. 3F, the cream solder 50 is printed on the surface mounting portion of the back surface of the printed wiring board 10 using the squeeze 40, metal mask 30 and the like. In a step shown in FIG. 3G, the surface mounting component 65 is mounted on the surface mounting portion on which the cream solder has been printed. In a step shown in FIG. 3H, the surface mounting component 65 mounted on the surface mounting portion is soldered by the reflow device.

Subsequently, in the flow process shown in FIGS. 3I to 3K, in a step shown in FIG. 3I, the lead wire 61 of the electronic component provided with the lead wire 60 is inserted into each through hole 20 of the lead component mounting portion to mount the electronic component provided with the lead wire 60 on the lead component mounting portion. In a step shown in FIG. 3J, the electronic component provided with the lead wire 60 is soldered by the jet solder from the back surface of the flow device 90. In a step shown in FIG. 3K, the printed wiring board 10 on which the electronic component provided with the lead wire 60 and the surface mounting components 65 are mounted is fed as a printed circuit board (circuit board) to the next step.

When the flow device 90 for soldering the lead wire 61 of the electronic component provided with the lead wire 60 is disposed in a reflow zone of the surface mounting component, and the lead wire 61 disposed in the electronic component provided with the lead wire 60 is soldered/bonded to the through hole 20 using the heat in the reflow zone, the component lead wire 61 can be more securely molten and solder-bonded by the cream solder 50. That is, while keeping the remaining heat state of the printed wiring board 10 heated in the reflow zone, the component lead wire 61 is soldered by the flow device 90. Accordingly, the soldering time of the component lead wire 61 by the flow device 90 can be shortened, and the melting and solder bonding by the cream solder 50 can be more securely performed.

In the third embodiment, the flow device 90 for soldering the lead wire 61 of the electronic component provided with the lead wire 60 is disposed in the reflow zone of the surface mounting component. However, the flow device 90 does not have to be necessarily disposed in the reflow zone in a manufacturing line environment in which the printed wiring board 10 can be transferred to the soldering step of the flow device 90 while sufficiently keeping the remaining heat state of the board heated in the reflow zone.

Next, a fourth embodiment of the present invention will be described.

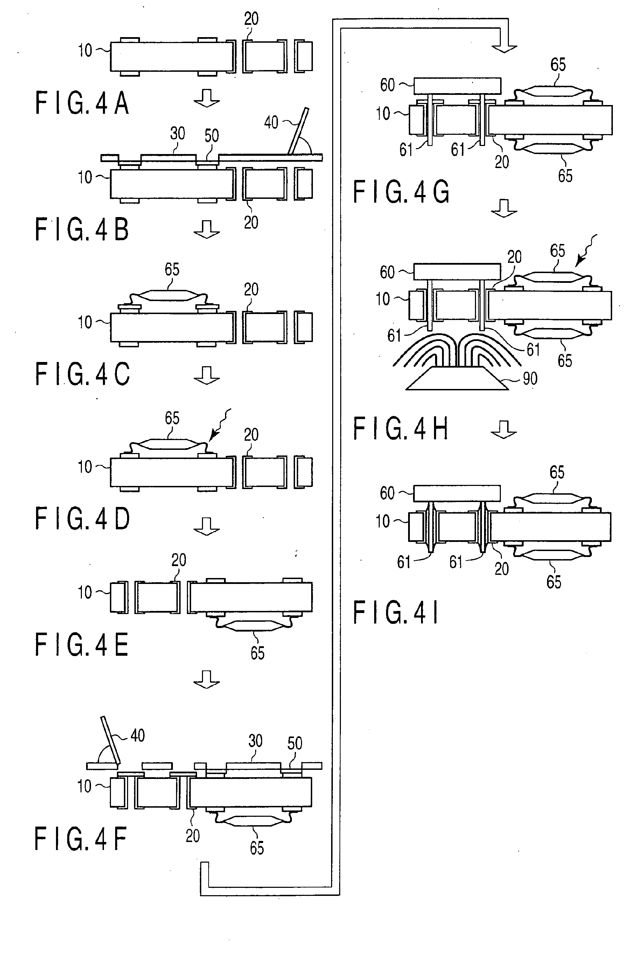

FIGS. 4A to 4I are diagrams showing the soldering mounting process of the electronic component provided with the lead wire in the fourth embodiment of the present invention.

In the fourth embodiment, the soldering process of the component lead wire 61 by the flow device 90 using the reflow zone is performed more efficiently in FIGS. 3A to 3K. Here, in the reflow process on two front and back surfaces, the component lead wire 61 is soldered effectively using a solder melting heat in the reflow process of the remaining surface. Accordingly, the lead wire 61 disposed in the electronic component provided with the lead wire 60 can be soldered in a satisfactory solder rising state more efficiently than in the third embodiment.

In a first reflow process shown in FIGS. 4A to 4D, the surface mounting component 65 is mounted and soldered on one surface (e.g., the front surface) of the printed wiring board 10. Subsequently, in the flow process shown in FIGS. 3E to 3G, the cream solder is printed, and the electronic component provided with the lead wire 60 and surface mounting component 65 are mounted on the other surface (e.g., the back surface) of the printed wiring board 10. Subsequently, in a second reflow process shown in FIGS. 3H to 3I, on the other surface (e.g., the back surface) of the printed wiring board 10, the surface mounting component 65 is reflow-soldered, and the electronic component provided with the lead wire 60 is soldered by the jet solder of the flow device 90 from the back surface and by the soldering melting heat of the reflow from the front surface.

In the first reflow process shown in FIGS. 4A to 4D, in a step shown in FIG. 4A, the printed wiring board 10 is projected as the component mounted printed wiring board into a reflow line. In a step shown in FIG. 4B, the cream solder 50 is printed, for example, on the surface mounting portion of the front surface of the printed wiring board 10 projected in the reflow line using the squeeze 40, the metal mask 30 and the like. In a step shown in FIG. 4C, the surface mounting component 65 is mounted on the surface mounting portion on which the cream solder is printed. In a step shown in FIG. 4D, the surface mounting component 65 mounted on the surface mounting portion is soldered by the reflow device.

Subsequently, in the second reflow process shown in FIGS. 4E to 4I, in a step shown in FIG. 4E, the surface-treated printed wiring board 10 is reversed. In a step shown in FIG. 4F, the cream solder 50 is printed on the surface mounting portion of the back surface of the printed wiring board 10 using the squeeze 40, metal mask 30 and the like. In this case, the cream solder 50 is printed including the through hole 20 into which the component lead wire 61 is inserted. In a step shown in FIG. 4G, the surface mounting component 65 is mounted on the surface mounting portion on which the cream solder has been printed, and the lead wire 61 of the electronic component provided with the lead wire 60 is inserted into the through hole 20 on which the cream solder 50 is printed. In a step shown in FIG. 4H, the surface mounting component 65 mounted on the surface mounting portion is soldered by the reflow device. Furthermore, the electronic component provided with the lead wire 60 is soldered by the jet solder from the back surface of the flow device 90 and the reflow solder melting heat from the front surface. In a step shown in FIG. 4I, the printed wiring board 10 on which the electronic component provided with the lead wire 60 and surface mounting components 65 are mounted is fed as the printed circuit board (circuit board) to the next step.

In the reflow process of two front and back surfaces, the component lead wire 61 is soldered effectively using the solder melting heat in the reflow process of the remaining surface in this manner. Accordingly, the lead wire 61 disposed in the electronic component provided with the lead wire 60 is soldered more efficiently than in the third embodiment, while the solder rises satisfactorily.

Furthermore, in the fourth embodiment, heat history of the surface of the through hole 20 portion into which the component lead wire 61 is inserted is limited to one reflow. An oxidizing degree is less than that of the third embodiment in which the reflow is performed twice, and a synergistic effect that solder wettability is satisfactory can also be expected.

Next, a fifth embodiment of the present invention will be described.

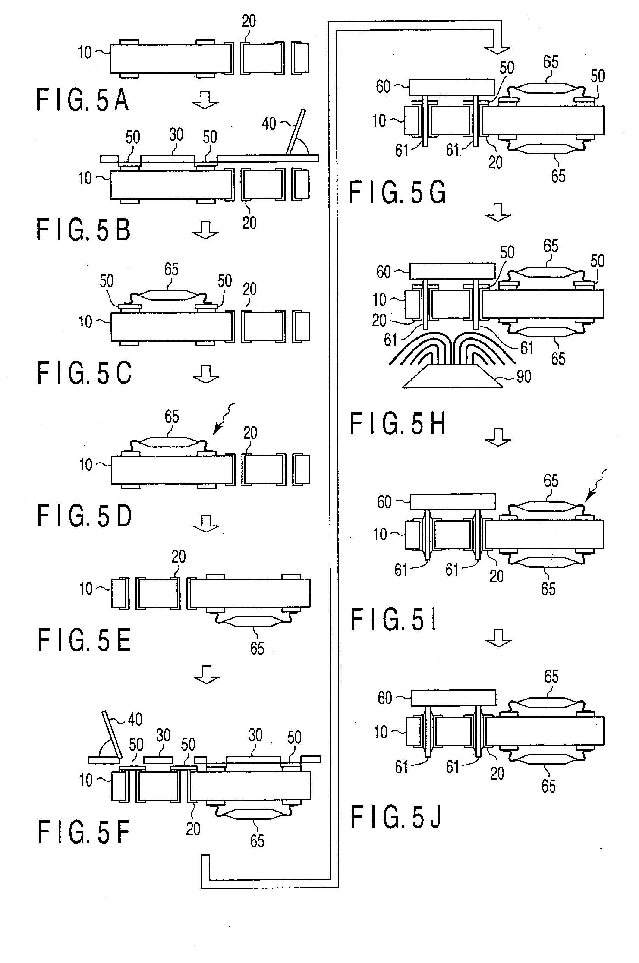

FIGS. 5A to 5J are diagrams showing the soldering mounting process of the electronic component provided with the lead wire in the fifth embodiment of the present invention.

In the fourth embodiment shown in FIGS. 4A to 4I, in the step shown in FIG. 4H, the reflow soldering of the surface mounting component 65, the flow of the electronic component provided with the lead wire 60, and the reflow soldering are performed simultaneously in parallel. On the other hand, in the fifth embodiment, the flow soldering of the electronic component provided with the lead wire 60 is performed separately from the reflow soldering of the surface mounting component 65. Therefore, the process of the respective steps in the fifth embodiment can be easily inferred from the fourth embodiment shown in FIGS. 4A to 4I, and here the detailed description is omitted.

In the fifth embodiment, in a step shown in FIG. 5H, the electronic component provided with the lead wire 60 is soldered by the jet solder from the back surface of the flow device 90. Subsequently, in a step shown in FIG. 5I, the surface mounting component 65 mounted on the surface mounting portion is soldered by the reflow device.

Also in the fifth embodiment, the lead wire 61 disposed in the electronic component provided with the lead wire 60 is soldered more efficiently than in the third embodiment in such a manner that the solder rises satisfactorily. Furthermore, the heat history of the surface of the through hole 20 portion into which the component lead wire 61 is inserted is limited to only one reflow. The oxidizing degree is less than that of the third embodiment in which the reflow is performed twice, and the synergistic effect that solder wettability is satisfactory can also be expected.

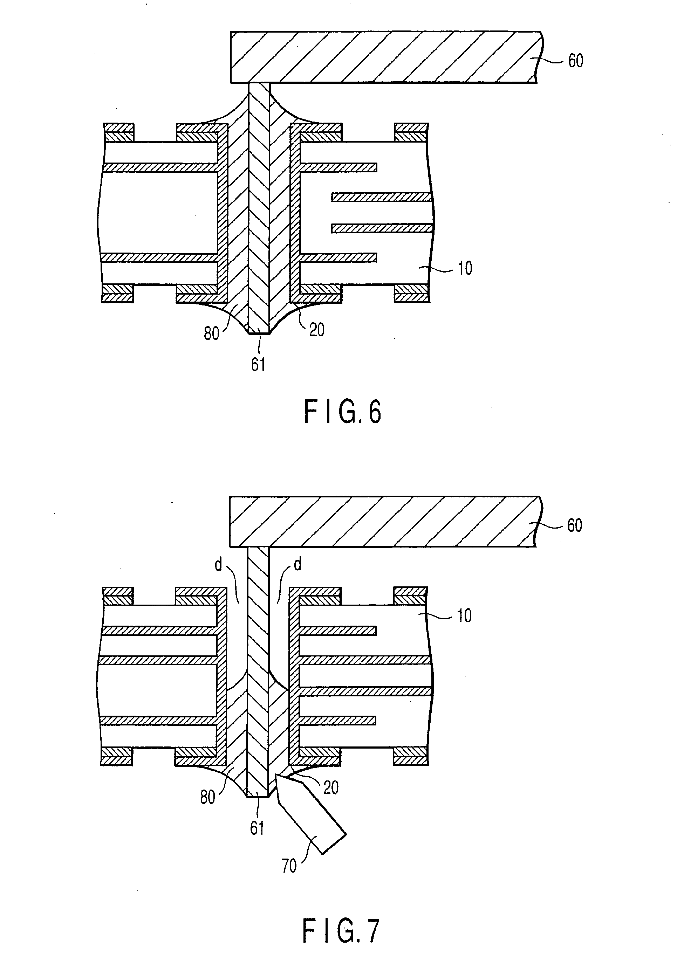

The solder rising state of the component lead wire 61 soldered/mounted by the soldering process in each of the above-described embodiments is shown in FIG. 6, and the solder rising state of the component lead wire 61 that can be caused by the existing soldering process to which the embodiments are not applied is shown in FIG. 7.

In the solder rising state shown in FIG. 6, a solder 80 is sufficiently turned (charged) in the through hole 20, and each lead wire 61 of the electronic component provided with the lead wire 60 is more firmly bonded/fixed to the through hole 20 by the solder 80 by satisfactory solder rising. Therefore, when the circuit board is mounted on the apparatus, the circuit is capable of sufficiently bearing any vibration, shock or the like, a stable circuit operation can be maintained over a long period, and this highly reliable electronic apparatus can be provided. In the solder rising state shown in FIG. 7, the solder 80 is not sufficiently turned (filled) in the through hole 20, a gap portion (d) by shortage of the solder is generated in the through hole 20, and a structure is vulnerable to external stress, vibration, or the like. Especially in small-sized electronic apparatuses such as a personal computer, PDA, and portable computer, a connector component to which the external stress is added is mounted in a peripheral portion of the substrate in many cases. When the embodiment of the present invention is applied to the component mounting portion, a highly reliable device capable of sufficiently bearing the external stresses such as the vibration and impact can be provided.

As described above in detail, according to the embodiments of the present invention, the solder rising is improved in a case where the lead wire of the electronic component provided with the lead wire is inserted into the through hole and soldered, and a highly reliable circuit board capable of sufficiently bearing the external stresses such as the vibration and shock can be manufactured.

Furthermore, a substrate manufacturing apparatus is applied to a substrate manufacturing line in which the surface mounting components are mounted on the opposite surfaces of the printed wiring board. Accordingly, when the lead wire of the electronic component provided with the lead wire is solder-bonded to the through hole, the electronic component provided with the lead wire and the surface mounting component can be soldered/mounted efficiently in a state in which the solder is sufficiently charged in the through hole.

## Claims

1. An electronic component mounting method of mounting an electronic component provided with a lead wire on a printed wiring board, **characterized by** comprising:
printing a cream solder on a through hole to which the lead wire of the electronic component provided with the lead wire is inserted;
inserting the electronic component provided with the lead wire into the through hole on which the cream solder has been printed; and
soldering the lead wire of the electronic component provided with the lead wire inserted into the through hole onto the through hole.

2. The electronic component mounting method according to claim 1, **characterized in that** the soldering comprises soldering the lead wire of the electronic component provided with the lead wire to the through hole using a soldering iron.

3. The electronic component mounting method according to claim 1, **characterized in that** the soldering comprises soldering the lead wire of the electronic component provided with the lead wire to the through hole by a jet solder of a flow device.

4. The electronic component mounting method according to claim 1, **characterized in that** the printing the cream solder is performed simultaneously with the printing of the cream solder onto a surface mounting portion on which a surface mounting component is to be mounted.

5. The electronic component mounting method according to claim 4, **characterized by** further comprising soldering the surface mounting component onto the surface mounting portion between the printing the cream solder and the soldering.

6. The electronic component mounting method according to claim 4, **characterized by** further comprising: soldering a surface mounting component onto a surface mounting portion of one surface of the printed wiring board; and printing the cream solder onto the surface mounting portion of the other surface of the printed wiring board to solder the surface mounting component, between the printing the cream solder and the soldering.

7. The electronic component mounting method according to claim 4, **characterized by** further comprising:
soldering a surface mounting component onto a surface mounting portion of one surface of the printed wiring board between the printing the cream solder and the soldering; and
printing the cream solder onto the surface mounting portion of the other surface of the printed wiring board to solder the surface mounting component after the soldering the electronic component provided with the lead wire.

8. A substrate manufacturing apparatus in which an electronic component (60) provided with a lead wire is mounted on a printed wiring board to manufacture a circuit board, the apparatus **characterized by** comprising:
solder printing means for printing a cream solder (50) onto a through hole (20) of the printed wiring board (10), into which the lead wire of the electronic component (60) provided with the lead wire is to be inserted;
lead insertion means for inserting the electronic component (60) provided with the lead wire into the through hole (20) of the printed wiring board (10), onto which the cream solder (50) has been printed; and
soldering means for soldering the lead wire of the electronic component (60) provided with the lead wire inserted in the through hole (20) onto the through hole (20).

9. The substrate manufacturing apparatus according to claim 8, **characterized in that** the solder printing means solders the lead wire of the electronic component provided with the lead wire onto the through hole using a flow device.

10. The substrate manufacturing apparatus according to claim 8, **characterized in that** the solder printing means performs the printing of the cream solder onto a surface mounting portion onto which a surface mounting component is to be mounted simultaneously with the printing of the cream solder onto the through hole.

11. The substrate manufacturing apparatus according to claim 10, **characterized by** further comprising: soldering means of the surface mounting component, for soldering the surface mounting component onto the surface mounting portion on which the cream solder has been printed by the solder printing means using a reflow device before soldering the electronic component provided with the lead wire.

12. The substrate manufacturing apparatus according to claim 11, **characterized by** further comprising: a flow device disposed in a heating zone of the reflow device, which solders the lead wire of the electronic component provided with the lead wire onto the through hole.

13. A circuit board **characterized by** comprising: a through hole into which a lead wire of an electronic component provided with the lead wire coated beforehand with a cream solder is inserted from a surface coated with the cream solder and onto which the lead wire is soldered to mount the electronic component.

14. The circuit board according to claim 13, **characterized in that** the through hole into which the lead wire is inserted is filled with the solder by reflow soldering using the cream solder and flow soldering from a tip side of the lead wire.

15. The circuit board according to claim 14, **characterized in that** a surface mounting component is reflow-soldered onto a surface mounting component mounting portion on the same plane as that of the mounting surface of the electronic component provided with the lead wire to mount the surface mounting component in parallel with the reflow soldering using the cream solder.
